# EUROPEAN PATENT APPLICATION

(11) **EP 4 752 627 A1**
(43) Date of publication of application: **03.06.2026**
(21) Application number: 24215667.7
(22) Date of filing: 27.11.2024
(51) Int. Cl.: G03F 7/00, H02K 41/03

(54) **ACTUATOR FOR A LITHOGRAPHIC APPARATUS**

(71) Applicant: ASML Netherlands B.V., 5500 AH Veldhoven (NL)
(72) Inventor: VAN DRENT, William, Peter, 5500 AH Veldhoven (NL)
(74) Representative: ASML Netherlands B.V.

(57) **Abstract**

An actuator (26) comprising a first magnetic assembly attached to a long stroke module (22) and comprising at least two first permanent magnets (36), a second magnetic assembly attached to a short stroke module and comprising at least one second permanent magnet (38). The first and second magnetic assemblies are configured to support the short stroke module with respect to the long stroke module (22) in a first direction (z). The second magnetic assembly is located between the first permanent magnets (36). The actuator includes an electrically conductive element (40) connectable to a power supply. The first magnetic assembly is longer than the second magnetic assembly in a second direction (x) to enable relative displacement of the short stroke module against the long stroke module (22), and the first magnetic assembly is geometrically configured such that a substantially homogeneous parallel magnetic field is provided.

## Description

### FIELD

The present invention relates to an actuator for a stage apparatus of a lithographic apparatus. The present invention also relates to a method comprising providing the actuator. The present invention also relates to a scanning and stepping exposure motion pattern method for the lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Stages as used in lithographic apparatuses typically have a Z-actuator (i.e. vertical direction actuator) integrated with a magnetic support system configured to compensate the weight of a substrate/object table. The magnetic support system may also be referred to as a magnetic gravity compensator. Such Z-actuator typically has a part mounted to a short stroke module (e.g. mounted to the substrate table) and a part mounted to a long stroke module of the stage. Typically, the short stroke module may be for enabling sub-nanometer accurate positioning of a mirror block of the substrate table. In contrast, the long stroke module may be for relatively larger movements, e.g. >100 µm, which may be e.g. for movement in a scanning direction for exposure of fields on a substrate.

It is desirable to provide an actuator which addresses a problem associated with the prior art. It is desirable to increase productivity by reducing the time between successive exposures in a lithographic apparatus.

### SUMMARY

According to a first aspect of the invention, there is provided an actuator for a stage apparatus of a lithographic apparatus, the actuator comprising: first and second magnetic assemblies, the first magnetic assembly is attached to a long stroke module or a short stroke module and comprises at least two first permanent magnets, the second magnetic assembly is attached to the short stroke module or the long stroke module and comprises at least one second permanent magnet, and the first and second magnetic assemblies are configured to magnetically cooperate with one another to support the short stroke module with respect to the long stroke module in a first direction, wherein one first permanent magnet is located on each side of a plane in which lies a common axis substantially parallel to a second direction perpendicular to the first direction, and wherein the second magnetic assembly is located between the first permanent magnets in a third direction substantially perpendicular to both the first and second directions, and an electrically conductive element connectable to a power supply, the electrically conductive element being configured to control a force in the first direction exerted on the second magnetic assembly from the first magnetic assembly, wherein the first magnetic assembly is longer than the second magnetic assembly in the second direction to enable relative displacement of the short stroke module and the long stroke module in the second direction and the first magnetic assembly is geometrically configured such that a substantially homogeneous parallel magnetic field is provided for a range of position of the second magnetic assembly in the second and/or third directions.

This may have an advantage of allowing increased relative displacement of the short stroke module and the long stroke module in the step (x) direction when compared to previous systems. This is whilst still providing the necessary support, stability, low z-stiffness variation across the entire desired motion range, and sufficient force actuation in the z direction whilst having a relatively flat force vs z direction characteristic.

This enables a new scanning method which uses the short stroke module to make the step (x direction) motion to move to the next field for exposure instead of the long stroke module. This in turn results in increased acceleration in the scanning direction, and thus, increases productivity of a lithographic apparatus by reducing time between successive exposures. That is, the increased movement range of the short stroke module in the step (x direction) facilitates a new associated exposure motion pattern for the lithographic apparatus. Previously the range of motion of the z-actuator (in the x direction) would not have allowed the necessary relative movement of the short stroke module and the long stroke module (in the x direction) for this motion pattern.

The first direction may be considered to be a vertical or z direction. Thus, the actuator may be considered to be a z-actuator.

The second direction may be considered to be a stepping or x direction. The third direction may be considered to be a scanning or y direction. The second and third directions may be considered to be horizontal directions.

The first and the second permanent magnets may be arranged to provide a bias force substantially along the first direction by magnetic interaction between the first and the second magnetic assemblies.

The bias force may be a constant force in the first direction to counteract gravity on a mass (e.g. the short stroke module etc) that is actuated by the actuator even when the electrically conductive element is inactive.

The first magnetic assembly and/or the second magnetic assembly may be geometrically configured such that the bias force (e.g. as provided by the magnetic interaction of all magnetic field generating elements (i.e. magnets and the electrically conductive element) in the assembly) is substantially independent from the position of the second magnetic assembly within its allowable range in the actuator. More particularly, the position may be the 6-degrees of freedom position (x, y, z rx, ry and rz), within the allowable 6-degrees of freedom range of the actuator. In practice the rx, ry and rz rotations may be small, and displacements in x, y and z (second, third and first directions respectively) are most important for the optimization strategy.

It will be appreciated that the net force in the first direction may change when the current in the coils is changed.

The first permanent magnets of the first magnetic assembly may be geometrically configured such that the magnitude of the force imparted by the first permanent magnets on the second permanent magnet of the second magnetic assembly in the first direction is substantially insensitive to position of the second permanent magnet in the second and/or third directions.

A force, or forces, imparted on the second permanent magnet of the second magnetic assembly is, or are, minimized in the second and/or third directions, regardless of the position of the second permanent magnet with respect to the first permanent magnets of the first magnetic assembly and the electrically conductive element in the second and/or third directions,

The first magnetic assembly may provide a homogeneous parallel magnetic field at the entire range of locations in the second and/or third directions where second permanent magnet of the second magnetic assembly may be positioned. The entire range of locations in both the second and/or third directions may be considered to be the allowable range of the second permanent magnet of the second magnetic assembly in the actuator.

The first magnetic assembly may extend substantially to or further than the maximum range of motion of the second magnetic assembly in the second direction.

The first permanent magnet of the first magnetic assembly on one side of the plane in which lies the common axis is not in contact with the first permanent magnet on the other side of the common axis. The second permanent magnet of the second magnetic assembly on one side of the plane in which lies the common axis is not in contact with the second permanent magnet on the other side of the plane in which lies the common axis substantially parallel to the second direction.

The relative displacement of the short stroke module and the long stroke module in the second direction may be greater than at least one of 1mm, 2mm, 3mm, 4mm and 5mm. The relative displacement of the short stroke module and the long stroke module in the second direction may be substantially at least one of a field width and 26mm. The relative displacement of the short stroke module and the long stroke module in the second direction may be in a range of at least one of greater than 1mm to 26mm, and greater than 1mm to a field width.

In use, the short stroke module may be supported by the long stroke module in the first direction such that the short stroke module is movable with respect to the long stroke module in the second direction and, to a lesser extent, in the third direction.

When the first magnetic assembly is attached to the long stroke module then the second magnetic assembly is attached to the short stroke module. When the first magnetic assembly is attached to the short stroke module then the second magnetic assembly is attached to the long stroke module.

The electrically conductive element may be an electromagnetic coil located between the first magnetic assembly and the second magnetic assembly or located externally to the first magnetic assembly.

The electromagnetic coil may extend in a plane perpendicular to the first direction.

The actuator may comprise an electromagnetic coil body. The electromagnetic coil and/or the electromagnetic coil body may be water cooled. The actuator may comprise a cooling system.

The electromagnetic coil may be longer in the second direction than in the third direction to enable the relative displacement of the short stroke module and the long stroke module in the second direction.

An internal diameter of the electromagnetic coil may be longer than the second magnetic assembly in the second direction.

The electromagnetic coil may be configured to be mounted to the long stroke module or the short stroke module.

When the first magnetic assembly is attached to the long stroke module and the second magnetic assembly is attached to the short stroke module, the electromagnetic coil may be attached to the long stroke module.

When the first magnetic assembly is attached to the short stroke module and the second magnetic assembly is attached to the long stroke module, the electromagnetic coil may be attached to the short stroke module.

The electrically conductive element may comprise at least two electromagnetic coils, wherein the at least two electromagnetic coils may be aligned in the first direction or aligned in the third direction with one electromagnetic coil located on each side of the plane in which lies the common axis substantially parallel to the second direction.

The electromagnetic coils may carry current in opposite directions. The current direction of the electromagnetic coils may be reversed in operation. The electromagnetic coils may both carry current in the same direction, or only one electromagnetic coil may carry current.

The two electromagnetic coils aligned in the first direction may be considered to extend parallel to a plane perpendicular to the first direction.

The two electromagnetic coils aligned in the third direction may be considered to extend parallel to a plane perpendicular to the third direction.

The first and second magnetic assemblies may be at least substantially reflectional symmetric around the plane in which lies the common axis substantially parallel to the second direction.

The first and second magnetic assemblies may be at least substantially 180 degree rotational symmetric around a common axis substantially parallel to the first direction.

The first magnetic assembly may define an internal space in the third direction and the second magnetic assembly may be at least partly located in the internal space.

The electromagnetic coil may be at least partly located in the internal space defined by the first magnetic assembly.

The electromagnetic coil may at least substantially circumscribe the second magnetic assembly in a plane perpendicular to the first direction.

The electromagnetic coil may define a further internal space in the third direction and the second magnetic assembly may be at least partly located in the further internal space.

The electromagnetic coil may at least substantially circumscribe the first magnetic assembly in a plane perpendicular to the first direction.

The first magnetic assembly and the second magnetic assembly may be at least partly located in the further internal space defined by the electromagnetic coil.

The first magnetic assembly may comprise at least four first permanent magnets with at least two first permanent magnets on each side of the plane in which lies the common axis substantially parallel to the second direction, wherein the two first permanent magnets on each side may be aligned in the second direction.

The first magnetic assembly may comprise more than four first permanent magnets.

The second magnetic assembly may comprise at least two second permanent magnets and wherein at least one of: one second permanent magnet may be located on each side of the plane in which lies the common axis substantially parallel to the second direction; and the two second permanent magnets may be aligned in the first direction and the two second permanent magnets may be located at the common axis substantially parallel to the first direction.

The first and the second permanent magnets may form sets of magnets, with each set comprising corresponding first and second permanent magnets located on opposing sides of the plane in which lies the common axis substantially parallel to the second direction.

One first permanent magnet may be orientated such that its magnetic polarization is substantially parallel or anti-parallel to the third direction and the other first permanent magnet may be orientated such that its magnetic polarization is substantially opposite.

One second permanent magnet may be orientated such that its magnetic polarization is opposite to the first permanent magnet on the same side of the plane in which lies the common axis substantially parallel to the second direction. The other second permanent magnet may be orientated such that its magnetic polarization is opposite to the first permanent magnet on the same side of the plane in which lies the common axis substantially parallel to the second direction.

The second permanent magnet(s) may have their magnetic polarization oriented so as to produce the bias force.

The second magnetic assembly may comprise at least four second permanent magnets with at least two second permanent magnets on each side of the plane in which lies the common axis substantially parallel to the second direction, wherein the two second permanent magnets on each side may be aligned in the first direction.

The second magnetic assembly may comprise more than four second permanent magnets.

The two second permanent magnets (e.g. on each side) may be spaced apart in the first direction to define a respective gap (or gaps where there are four second permanent magnets) therebetween. The actuator may comprise a Halbach (permanent) magnet (e.g. on each side of the plane in which lies the common axis) and located in the respective gap(s). That is, the Halbach magnet(s) may be (respectively) located (e.g. on each side) between the two respective second permanent magnets of the second magnetic assembly. Halbach magnets may be arranged with their magnetic polarization at an angle of 90 degrees to that of the adjacent second permanent magnet of the second magnetic assembly. The second magnetic assembly may be arranged in a so-called Halbach configuration. The Halbach configuration may be used to reduce the stray magnetic fields around the actuator and may also reduce the mass of the magnets used for a given static force. The Halbach magnets may be used for higher efficiency / weight reduction.

The first and second permanent magnets may be plane-parallel planar shaped magnets, wherein an in-plane dimension of the second permanent magnet or magnets in the second direction may be substantially smaller than a corresponding dimension of the first permanent magnets.

Plane-parallel may mean that at least surfaces of the first permanent magnets facing surfaces of the second permanent magnets are parallel to each other.

Planar shaped magnets may mean that surfaces of the first permanent magnets facing surfaces of the second permanent magnets are planar.

The first and the second permanent magnets may extend in parallel planes substantially perpendicular to the third direction.

The first permanent magnets may not extend toward each other in the third direction along their length in the second direction. That is, they may not bend towards each other at their ends in the second direction or extend even partially around the electromagnetic coil in the third direction.

The first magnetic assembly may extend to substantially the same extent as an internal diameter of the electromagnetic coil in the second direction.

The first magnetic assembly may extend to substantially the same extent as an outer diameter of the electromagnetic coil in the second direction.

The first magnetic assembly may extend to substantially further than an outer diameter of the electromagnetic coil in the second direction.

The first magnetic assembly may extend in a range from longer than the second magnetic assembly in the second direction to substantially the same extent as an outer diameter of the electromagnetic coil in the second direction.

The first magnetic assembly may have a reduced dimension in the third direction at or towards ends of the first magnetic assembly in the second direction when compared to a centre of the first magnetic assembly in the second direction. The first magnetic assembly may substantially taper in the third direction towards the ends of the first magnetic assembly. This may allow the magnetic field to be tailored towards the ends of the first magnetic assembly (e.g. to provide the homogenous parallel magnetic field).

The dimensions and/or shapes of the magnets, electromagnetic coils and cooling system may be, (e.g. using a magnetic calculation package) optimized to, e.g. yield a low z-stiffness (z being in the first direction) variation across the entire desired motion range; actuate in z (the first direction) with sufficient force while having a relatively flat force vs z (first direction) characteristic; imparting a minimized heat load on the environment; and minimize mass of the actuator.

According to a second aspect of the invention, there is provided a stage apparatus of a lithographic apparatus, the stage apparatus comprising the actuator as described above.

The stage apparatus may comprise the short stroke module and the long stroke module, wherein the long stroke module may be configured to: alternately move at a velocity of Vy and -Vy in the third direction for alternate exposures of a sequence of exposures and a velocity of Vx in the second direction for at least part of the exposure for each exposure of the sequence of exposures; and the short stroke module is configured to: move at a velocity of -Vx in the second direction during the at least part of the exposure such that a projection image is maintained in a predetermined position, and move, at the end of each exposure, at a velocity >Vx in the second direction for at least part of a distance to a position for the next exposure.

The second direction may be the stepping direction. The third direction may be the scanning direction.

The short stroke module may move correspondingly in the opposite direction to the long stroke module in the second direction for the at least part of the exposure.

The long stroke module may be configured to move the rest of the distance to the position for the next exposure.

The desired position may be to keep the projection image under a slit.

The long stroke module may be configured to: move at the velocity of Vx in the second direction for the sequence of exposures; and the short stroke module may be configured to: move at a velocity of -Vx in the second direction during each exposure such that the projection image is maintained in the predetermined position, and move, at the end of each exposure, at a velocity >Vx in the second direction to the position for the next exposure.

The long stroke module may be configured to not move to the position for the next exposure (since this may be done fully by the short stroke module).

The long stroke module may comprise a plurality of long stroke forcers, and wherein an equal number or a majority of the long stroke forcers may be configured to provide movement in the third direction and an equal number or a minority of the long stroke forcers may be configured to provide movement in the second direction.

This may have an advantage of increasing acceleration in the third (scanning) direction. This may be because freed up long stroke forcers may be dedicated to increase acceleration in the third (scanning) direction since previously these long stroke forcers may have provided acceleration in the second (step) direction.

Acceleration in the second (step) direction may be in range of at least one of: 100 to 200ms-2 and 100 to 300ms-2. Acceleration in the third (scanning) direction may be in range of at least one of: 40 to 70ms-2, 40 to 100ms-2 and 40 to 150ms-2.

There may be four long stroke forcers configured to provide movement in the third direction. There may be two long stroke forcers configured to provide movement in the second direction.

There may be three long stroke forcers configured to provide movement in the third direction. There may be three long stroke forcers configured to provide movement in the second direction.

The short stroke module may comprise a plurality of short stroke forcers, and wherein the short stroke forcers may comprise at least one of: forcers configured to provide movement in both the second and third directions, and 3-phase linear motors.

There may be two, three or four short stroke forcers.

Each 3-phase linear motor may comprise motor coils (e.g. 3) and alternating magnet sets (e.g. 5) as the yoke. The motor coils may be orientated in the third direction.

The short stroke forcer may comprise at least one Halbach magnet.

Magnets of the short stroke forcer may be slanted. This may provide less cogging.

According to a third aspect of the invention, there is provided a lithographic apparatus comprising the actuator as described above or the stage apparatus as described above.

The lithographic apparatus may be an EUV lithographic apparatus.

According to a fourth aspect of the invention, there is provided a method comprising providing an actuator for a stage apparatus of a lithographic apparatus, the method comprising providing: first and second magnetic assemblies, the first magnetic assembly is attached to a long stroke module or a short stroke module and comprises at least two first permanent magnets, the second magnetic assembly is attached to the short stroke module or the long stroke module and comprises at least one second permanent magnet, and the first and second magnetic assemblies are configured to magnetically cooperate with one another to support the short stroke module with respect to the long stroke module in a first direction, wherein one first permanent magnet is located on each side of a plane in which lies a common axis substantially parallel to a second direction perpendicular to the first direction, and wherein the second magnetic assembly is located between the first permanent magnets in a third direction substantially perpendicular to both the first and second directions, and an electrically conductive element connectable to a power supply, the electrically conductive element being configured to control a force in the first direction exerted on the second magnetic assembly from the first magnetic assembly, wherein the first magnetic assembly is longer than the second magnetic assembly in the second direction to enable relative displacement of the short stroke module and the long stroke module in the second direction and the first magnetic assembly is geometrically configured such that a substantially homogeneous parallel magnetic field is provided for a range of position of the second magnetic assembly in the second and/or third directions.

The stage apparatus may comprise the short stroke module and the long stroke module, the method may comprise: moving the long stroke module alternately at a velocity of Vy and -Vy in the third direction for alternate exposures of a sequence of exposures and a velocity of Vx in the second direction for at least part of the exposure for each exposure of the sequence of exposures; moving the short stroke module at a velocity of -Vx in the second direction during the at least part of the exposure such that a projection image is maintained in a predetermined position, and moving the short stroke module, at the end of each exposure, at a velocity >Vx in the second direction for at least part of a distance to a position for the next exposure.

According to a fifth aspect of the invention, there is provided a stage apparatus comprising a short stroke module and a long stroke module, wherein the long stroke module may be configured to: alternately move at a velocity of Vy and -Vy in the third direction for alternate exposures of a sequence of exposures and a velocity of Vx in the second direction for at least part of the exposure for each exposure of the sequence of exposures; and the short stroke module is configured to: move at a velocity of -Vx in the second direction during the at least part of the exposure such that a projection image is maintained in a predetermined position, and move, at the end of each exposure, at a velocity >Vx in the second direction for at least part of a distance to a position for the next exposure.

The long stroke module may be configured to: move at the velocity of Vx in the second direction for the sequence of exposures; and the short stroke module may be configured to: move at a velocity of -Vx in the second direction during each exposure such that the projection image is maintained in the predetermined position, and move, at the end of each exposure, at a velocity >Vx in the second direction to the position for the next exposure.

According to a sixth aspect of the invention, there is provided a method comprising, wherein the stage apparatus comprises a short stroke module and a long stroke module: moving the long stroke module alternately at a velocity of Vy and -Vy in the third direction for alternate exposures of a sequence of exposures and a velocity of Vx in the second direction for at least part of the exposure for each exposure of the sequence of exposures; moving the short stroke module at a velocity of -Vx in the second direction during the at least part of the exposure such that a projection image is maintained in a predetermined position, and moving the short stroke module, at the end of each exposure, at a velocity >Vx in the second direction for at least part of a distance to a position for the next exposure.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a stage apparatus with a long stroke module, a short stroke module and z-actuators;
- Figure 3 depicts a cross sectional side view of a z-actuator;
- Figure 4A depicts a top view of the z-actuator of Figure 3 at a nominal position;
- Figure 4B depicts a top view of the z-actuator of Figure 3 at an end position;
- Figure 5A depicts a top view of a z-actuator at an end position;
- Figure 5B depicts a top view of a z-actuator at an end position;
- Figure 5C depicts a top view of a z-actuator at a nominal position;
- Figure 6A depicts a cross sectional side view of a z-actuator;
- Figure 6B depicts a cross sectional side view of an electromagnetic coil of the z-actuator of Figure 6A;
- Figure 7A depicts a cross sectional side view of a z-actuator;
- Figure 7B depicts a cross sectional side view of the z-actuator of Figure 7A;
- Figure 8 depicts a long stroke module and a short stroke module at different times during exposures;
- Figure 9 depicts forcers for a long stroke module;
- Figure 10 depicts forcers for a long stroke module;
- Figure 11 depicts a long stroke module and a short stroke module with z-actuators and x/y-forcers;
- Figure 12 depicts an x/y forcer for a short stroke module.

### DETAILED DESCRIPTION

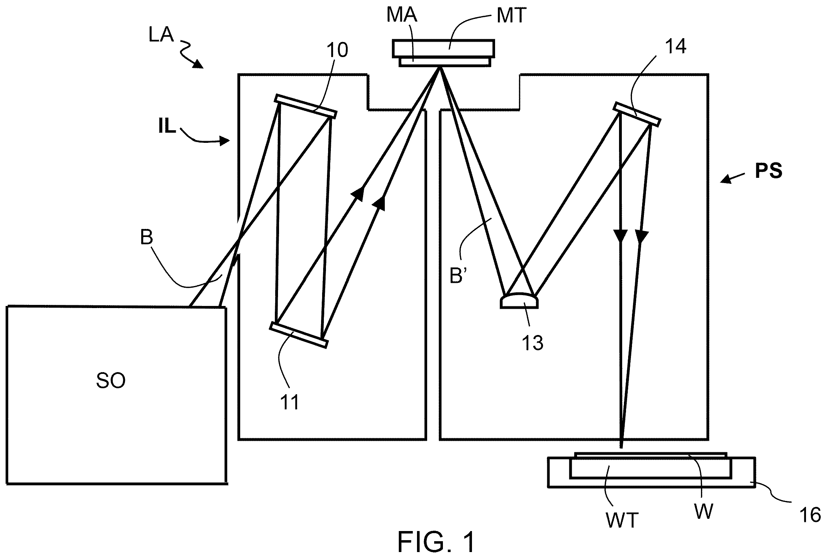

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

A substrate stage apparatus 16, which may be referred to more generally as a stage, stage apparatus or positioning module, is provided to support and move the substrate W. It will be appreciated that the substrate table WT may form part of the substrate stage apparatus 16.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

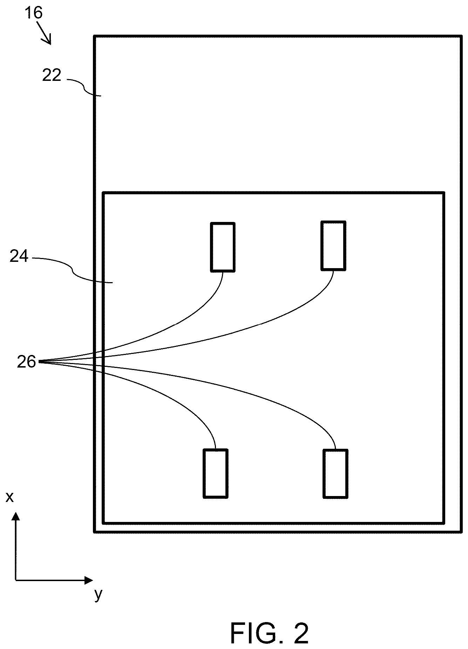

Figure 2 shows a schematic top view of the substrate stage apparatus 16 with some of its parts omitted for clarity. For example, a mirror block and the substrate table WT (which may both form part of the substrate stage apparatus 16) are not shown. The substrate stage apparatus 16 comprises a long stroke module 22 and a short stroke module 24. The long stroke module 22 may be for relatively larger movements, e.g. >100 µm, which may be e.g. for movement in a scanning direction (i.e. the y direction) for exposure by the patterned EUV radiation beam B' of fields on the substrate W. The short stroke module 24 may be for enabling sub-nanometer accurate positioning of the mirror block of the substrate table WT.

The substrate stage apparatus 16 includes a plurality of actuators 26. In this embodiment, four actuators 26 are shown but, in other embodiments, there may be a different number of actuators, e.g. 1, 2, 3 or 5 or more. The actuators 26 may be considered to be gravity compensators. Through the actuators 26, the short stroke module 24 is supported by the long stroke module 22 in the z direction (out of the page) such that the short stroke module 24 is movable with respect to the long stroke module 22 in the x direction and, to a lesser extent, in the y direction as will become apparent. The z direction may be considered to be a first direction. The z direction may be considered to be a vertical direction. The x direction (i.e. a stepping direction) may be considered to be a second direction. The y direction (i.e. the scanning direction) may be considered to be a third direction. The x direction and the y direction may be considered to be horizontal directions.

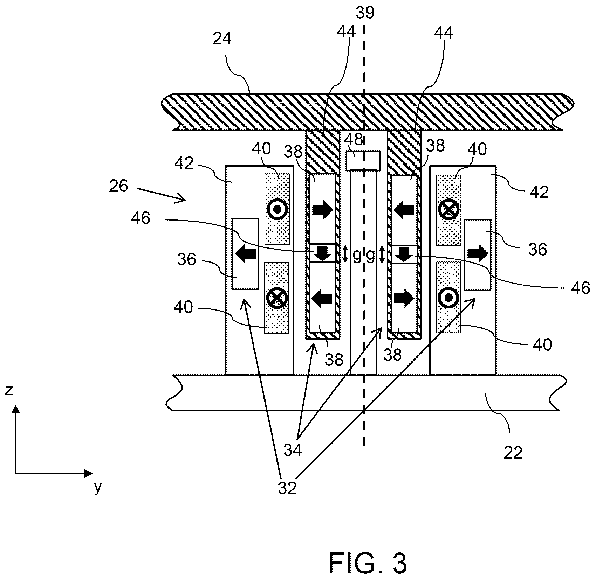

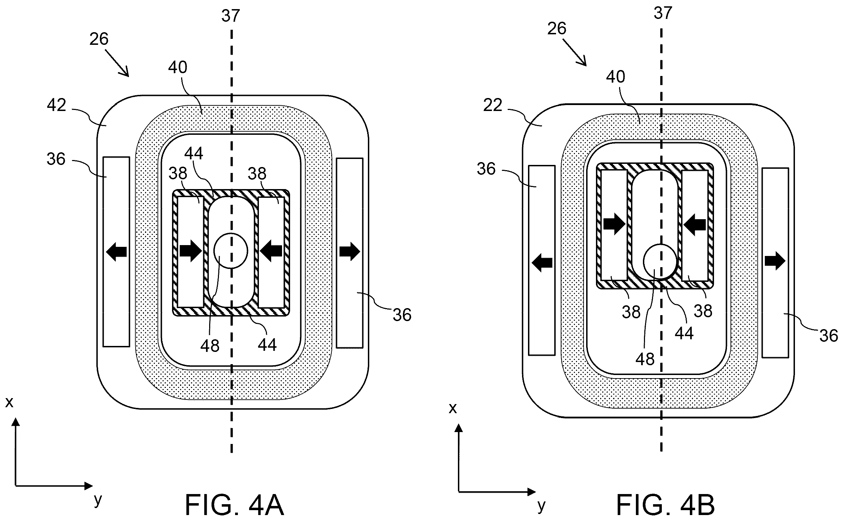

Figure 3 depicts a cross sectional view of the actuator 26 taken along the y direction and Figure 4A depicts a top view of the actuator 26 (the short stroke module 24 and the long stroke module 22 are not shown). Although only one actuator 26 will now be described, it will be appreciated that the same features are included in each of the actuators 26 depicted in Figure 2.

The actuator 26 includes a first magnetic assembly 32 and a second magnetic assembly 34, with the first magnetic assembly 32 defining an internal space in the y direction and the second magnetic assembly 34 being located in the internal space.

The first magnetic assembly 32 includes two first permanent magnets 36, with the first permanent magnets 36 being located either side of an xz plane 37 (see dashed line in Figure 4A) in which lies a common axis substantially parallel to the x direction. That is, one of the first permanent magnets 36 is located on one side of the xz plane 37 and the other first permanent magnet 36 is located on the other side of the xz plane 37. The common axis is common (and centrally located) with respect to the first and second magnetic assemblies 32, 34.

The second magnetic assembly 34 includes four second permanent magnets 38, with two of the second permanent magnets 38 being located on one side of the xz plane 37 and the other two second permanent magnets 36 being located on the other side of the xz plane 37. The two second permanent magnets 38 on each side of the xz plane 37 are aligned in the z direction. That is, there is a second permanent magnet 38 above the other second permanent magnet 38 on each side of the xz plane 37. Only the upper two second permanent magnets 38 (one on each side of the xz plane 37) are shown in Figure 4A, with the lower second permanent magnets 38 being located below. It will be appreciated that this is just an embodiment and the first and second magnet assemblies may have a different number of magnets and arrangements.

The first and second magnetic assemblies 32, 34 are at least substantially reflectional symmetric about the xz plane 37 in which lies the common axis substantially parallel to the x direction. The first and the second permanent magnets 36, 38 may be considered to form sets of magnets, with each set comprising corresponding first and second permanent magnets 36, 38 located on opposing sides of the xz plane 37. The first and second magnetic assemblies 32, 34 are at least substantially 180 degree rotational symmetric around a common axis 39 (see dashed line in Figure 3) substantially parallel to the z direction. The common axis 39 is common (and centrally located) with respect to the first and second magnetic assemblies 32, 34. It will be appreciated that the common axis 39 also lies in the xz plane 37.

The first and second magnetic assemblies 32, 34 are configured to magnetically cooperate with one another to support the short stroke module 24 with respect to the long stroke module 22 in the z direction. The first and the second permanent magnets 36, 38 are orientated such that their magnetic polarizations are orientated in such a way to enable this support. The second permanent magnets 38 have their magnetic polarization oriented so as to produce a bias force substantially along the z direction by magnetic interaction between the first and the second magnetic assemblies 32, 34. The bias force may be a constant force in the z direction to counteract gravity on a mass (e.g. the short stroke module etc) that is actuated by the actuator 26 even when the electrically conductive element is inactive.

More particularly, one first permanent magnet 36 may be orientated such that its magnetic polarization is substantially parallel or anti-parallel to the y direction and the other first permanent magnet 36 may be orientated such that its magnetic polarization is substantially opposite. This is illustrated in Figures 3 and 4A where the first permanent magnet 36 at the left side has its magnetic polarization (shown by an arrow) orientated to the left (i.e. anti-parallel to the y direction) and the first permanent magnet 36 at the right side has its magnetic polarization orientated to the right (parallel to the y direction).

Furthermore, one of the upper second permanent magnets 38 may be orientated such that its magnetic polarization is opposite to the first permanent magnet 36 on the same side of the xz plane 37 in which lies the common axis substantially parallel to the x direction. The other upper second permanent magnet 38 may be orientated such that its magnetic polarization is opposite to the first permanent magnet 36 on the same side of the xz plane 37. One of the lower second permanent magnets 38 may be orientated such that its magnetic polarization is in the same direction as the first permanent magnet 36 on the same side of the xz plane 37. The other lower second permanent magnet 38 may be orientated such that its magnetic polarization is in the same direction as the first permanent magnet 36 on the same side of the xz plane 37. In this situation, the magnetic polarization of the upper second permanent magnets 38 are in opposite directions and facing each other. That is, the upper second permanent magnet 38 at the left side has its magnetic polarization orientated to the right (i.e. parallel to the y direction) and the upper second permanent magnet 38 at the right side has its magnetic polarization orientated to the left (anti-parallel to the y direction). In this situation, the magnetic polarization of the lower second permanent magnets 38 are in opposite directions and facing away from each other. That is, the lower second permanent magnet 38 at the left side has its magnetic polarization orientated to the left (i.e. anti-parallel to the y direction) and the lower second permanent magnet 38 at the right side has its magnetic polarization orientated to the right (parallel to the y direction). It will be appreciated that this is just an embodiment and the orientation of the first and the second permanent magnets (and thus the direction of their magnetic polarization) may be different.

The actuator 26 also includes two electromagnetic coils 40, an upper electromagnetic coil and a lower electromagnetic coil aligned in the z direction, located between the first magnetic assembly 32 and the second magnetic assembly 34. More generally, the electromagnetic coils may be considered to be electrically conductive elements connectable to a power supply. It will be appreciated that this is just an embodiment there may be a different number of electromagnetic coils, e.g. 1 or 3 or more.

The upper electromagnetic coil 40 extends in a plane perpendicular to the z direction (i.e. an xy plane) and the lower electromagnetic coil 40 extends in another parallel plane perpendicular to the z direction (i.e. an xy plane). The electromagnetic coils 40 are at least partly located in the internal space defined by the first magnetic assembly 32. The electromagnetic coils 40 define a further internal space in the y direction and the second magnetic assembly 34 is at least partly located in the further internal space. The electromagnetic coils 40 are configured to control a force in the z direction exerted on the second magnetic assembly 34 from the first magnetic assembly 32. It will be appreciated that this is just an embodiment and the electromagnetic coil may be located in another position. For example, the electromagnetic coil may be located externally to the first magnetic assembly (and the second magnetic assembly) such that the first magnetic assembly (and the second magnetic assembly) are located in the further internal space. This may enable a higher z-force (or may allow the magnets to be smaller) but more current may be needed to control the z-force by the electromagnetic coil.

The electromagnetic coils 40 may carry current in opposite directions (see Figure 3 for example current directions). The current direction of the electromagnetic coils 40 may be reversed in operation. It will be appreciated that this is just an embodiment and the current directions may be different, e.g. the electromagnetic coils may both carry current in the same direction, or only one electromagnetic coil may carry current.

The first permanent magnets 36 and the electromagnetic coils 40 are mounted to the long stroke module 22 and are housed in an electromagnetic coil body 42. The electromagnetic coil body 42 is attached to the long stroke module 22. This may be preferred because both electrical power and possible liquid cooling may be supplied from the long stroke module. It may be desired to have the minimum number of connections between the long stroke module and the short stroke module to minimize stiffness between the long stroke module and the short stroke module. The electromagnetic coils 40 and/or the electromagnetic coil body 42 may be water cooled. The actuator 26 may comprise a cooling system.

The second permanent magnets 38 are mounted to the short stroke module 24 and are housed in a magnetic housing 44. The magnetic housing 44 is attached to the short stroke module 24. It will be appreciated that, in another embodiment, the first permanent magnets may be mounted to the short stroke module and the second permanent magnets may be mounted to the long stroke module. In this case, the electromagnetic coil (and electromagnetic body) may be attached to the short stroke module. It may be considered that, in this embodiment, the arrangement is mounted 'upside down' from the other embodiment. It will be appreciated that it is generally described here that the first permanent magnets are mounted to the long stroke module and the second permanent magnets are mounted to the short stroke module but, in the opposite situation, it should be read accordingly with any changes being made for clarity and functionality.

The two second permanent magnets 38 on each side of the xz plane 37 in which lies the common axis substantially parallel to the x direction may be spaced apart in the z direction to define respective gaps g therebetween. The actuator 26 includes Halbach (permanent) magnets 46 on each side of the xz plane 37 and located in the respective gaps g. That is, the Halbach magnets 46 are respectively located on each side of the xz plane 37 between the two respective second permanent magnets 38. The Halbach magnets 46 are arranged with their magnetic polarization at an angle of 90 degrees to that of adjacent second permanent magnets 38. The second magnetic assembly 32 is arranged in a so-called Halbach configuration. The Halbach configuration may be used to reduce the stray magnetic fields around the actuator 26 and may also reduce the mass of the magnets used for a given static force. The Halbach magnets 46 may be used for higher efficiency / weight reduction. It will be appreciated that this is just an embodiment and there may be none or a different number, e.g. 1 or more than 3, of Halbach magnets. Furthermore, the Halbach magnets may have a different orientation from as shown in Figure 3.

As best seen in Figure 4A, the first and second permanent magnets 36, 38 are plane-parallel planar shaped magnets (i.e. bar-like magnets). Plane-parallel may mean that at least (inner) surfaces of the first permanent magnets 36 facing (outer) surfaces of the second permanent magnets 38 are parallel to each other. Planar shaped may mean that surfaces of the first permanent magnets 36 facing surfaces of the second permanent magnets 38 are planar. The first and the second permanent magnets 36, 38 extend in parallel planes substantially perpendicular to the y direction (i.e. in parallel xz planes). An in-plane (i.e. xz plane) dimension of the second permanent magnets 38 is substantially smaller (i.e. shorter) than a corresponding dimension of the first permanent magnets 36. That is, the first permanent magnets 36 are substantially longer than the second permanent magnets 38 in the x direction.

The first permanent magnets 36 and the second permanent magnets 38 are both elongated in the x direction (i.e. substantially longer in the x direction than in the y direction [and z direction]). However, the first permanent magnets 36 are more elongated than the second permanent magnets 38.

In the embodiment of Figure 4A, the first permanent magnets 36 extend substantially less than an internal diameter of the electromagnetic coil 40 in the x direction. The first permanent magnets 36 may extend substantially to the maximum range of motion of the second permanent magnets 38 in the x direction. The first permanent magnets 36 provide a homogeneous parallel magnetic field at the entire range of locations in both the x direction and the y direction where the second permanent magnets 38 may be positioned.

The electromagnetic coils 40 are longer in the x direction than in the y direction. The electromagnetic coils 40 are both elongated in the x direction (i.e. substantially longer in the x direction than in the y direction [and z direction]). Internal diameters of the electromagnetic coils 40 are longer than the second permanent magnets 38 in the x direction.

Since the first permanent magnets 36 are longer than the second permanent magnets in the x direction, and the electromagnetic coils 40 are elongated in the x direction, the second permanent magnets 38 can move within the electromagnetic coils 40 such that the short stroke module 34 is displaced in the x direction relative to the long stroke module 32 whilst still providing the necessary support, stability, low z-stiffness variation across the entire desired motion range, and sufficient force actuation in the z direction whilst having a relatively flat force vs z direction characteristic. Here z-stiffness vs position can be minimized and z-motor constant can be made near invariant vs xyz position.

Figure 4A shows a top view of the z-actuator at a nominal position, i.e. with an end of stroke pin 48 substantially centred in both the x and y directions with respect to the first and second magnetic assemblies 32, 34. It can be seen from Figure 3 that the common axis 39 intersects the stroke pin 48 in this position. Figure 4B shows a top view of the actuator 26 at an end position, i.e. with the second magnetic assembly 34 at its maximum range of motion in both the x direction and the y direction. The stroke pin 48 coming into contact with the magnetic housing 44 constrains the motion.

It can be appreciated that the second magnetic assembly 34 can move substantially further in the x direction than in the y direction. This allows a greater range of motion in the x direction for the short stroke module 24 with respect to the long stroke module 22 when compared with previous systems. For example, with the arrangement of Figures 3, 4A and 4B, the range of motion in the x direction may be greater than 1mm, greater than 5mm and may be of the order of 10s of mm, e.g. up to 26mm or potentially more. The range of motion in the y direction may be a maximum of e.g. 1mm.

Previous systems may have concentric circular magnetic assemblies which only allowed substantially similar or the same range of motion in both the x direction and the y direction. Furthermore, the range of motion may have been relatively small. For example, this previous range of motion may have been limited to a maximum of about 1mm in both the x and y direction, or at least less than 5mm. In addition, previous concentric circular magnetic assemblies would not have a homogeneous parallel magnetic field, rather there would be a circular magnetic field.

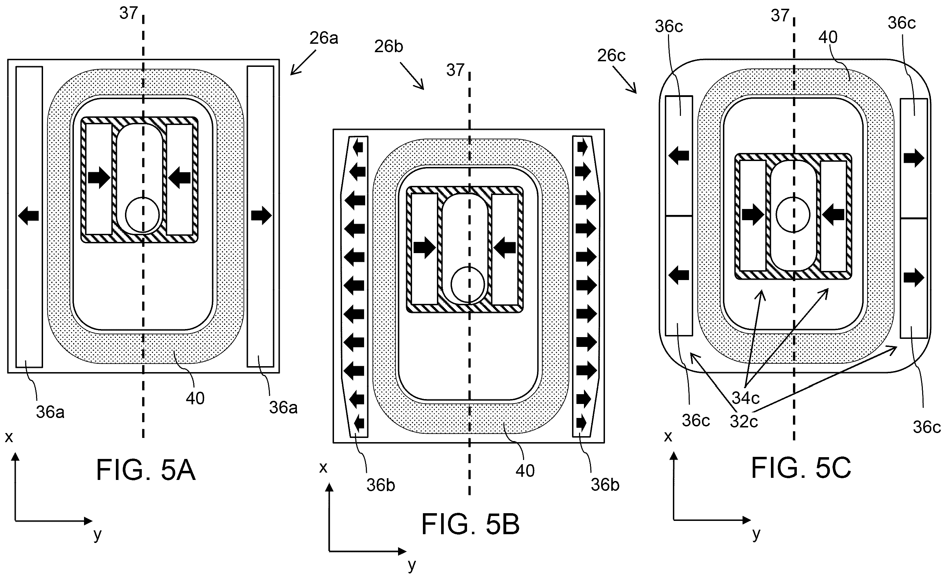

Figure 5A depicts a top view of an actuator 26a of another embodiment. For clarity, the same reference numerals have been used or not included for the same parts as in Figure 3, 4A, and 4B with new or different parts being provided with a new reference numeral or with an additional letter, e.g. a, b, c and so on. Figure 5A is different from Figure 4A in that first permanent magnets 36a in Figure 5A are longer in the x direction than the first permanent magnets 36 in Figure 4A. The first permanent magnets 36a extend in the x direction to substantially the same extent as an outer diameter of the electromagnetic coil 40 in the x direction. More generally, the first magnetic assembly may extend in a range from longer than the second magnetic assembly in the x direction to substantially the same extent as an outer diameter of the electromagnetic coil in the x direction. In other embodiments, the first permanent magnets may extend in the x direction to substantially further than an outer diameter of the electromagnetic coil in the x direction.

Figure 5B depicts a top view of an actuator 26b of another embodiment. Figure 5A is different from Figure 5B in that first permanent magnets 36b in Figure 5B are shaped differently than the first permanent magnets 36a in Figure 5A. The first permanent magnets 36b have a reduced dimension in the y direction at or towards ends of the first permanent magnets 36b in the x direction when compared to a centre of the first permanent magnets 36b in the x direction. The first permanent magnets 36b substantially taper in the y direction towards the ends of the first permanent magnets 36b. More particularly, outer surfaces (i.e. surfaces facing away from the second permanent magnets 38) of the first permanent magnets 36b taper inwards towards the xz plane 37 as they extend towards the ends of the first permanent magnets 36b in the x direction. This may allow the magnetic field to be tailored towards the ends of the first magnetic assembly (e.g. to provide the homogenous parallel magnetic field). The smaller arrows in the first permanent magnets 36' (extending less in the y direction) illustrate a reduced magnetic field in these areas. In other embodiments, the first permanent magnets may have a different shape at or near the ends. It will be appreciated that, e.g. by means of simulations (e.g. FEM), the magnets may be shaped such that the field remains as homogeneous as possible or desired. In embodiments, the first permanent magnets may have an increased thickness in the y direction at or towards ends of the first permanent magnets in the x direction when compared to a centre of the first permanent magnets in the x direction. Furthermore, the height of the magnets (i.e. the dimension in the z direction) may be considered to vary along the x direction. It will be appreciated that the dimensions and/or shapes of the magnets, electromagnetic coils and cooling system may be, (e.g. using a magnetic calculation package) optimized to, e.g. yield a low z-stiffness (z being in the first direction) variation across the entire desired motion range; actuate in z (the first direction) with sufficient force while having a relatively flat force vs z (first direction) characteristic; impart a minimized heat load on the environment; and minimize mass of the actuator.

Figure 5C depicts a top view of an actuator 26c of another embodiment. Figure 5c is different from Figure 4A in that there are four first permanent magnets 36c in Figure 5C rather than the two first permanent magnets 36 in Figure 4A. That is, the first magnetic assembly 32c comprises four first permanent magnets 36c, with two first permanent magnets 36c on each side of the xz plane 37 in which lies the common axis substantially parallel to the x direction. The two first permanent magnets 36c on each side of the xz plane 37 are aligned in the x direction. In this way, it will be appreciated that the first magnetic assembly 32c is longer than the second magnetic assembly 34c in the x direction. The first magnetic assembly 32c may extend in the x direction to substantially the same extent, less or further than an inner diameter of the electromagnetic coil 40 in the x direction. In general, the first magnetic assembly 32c may extend substantially to at least the maximum range of motion of the second magnetic assembly 34c in the x direction. In this embodiment, there is substantially no gap between the first permanent magnets 36c aligned in the x direction but in other embodiments there may be a gap and/or there may be a different number of first permanent magnets, such as more than four.

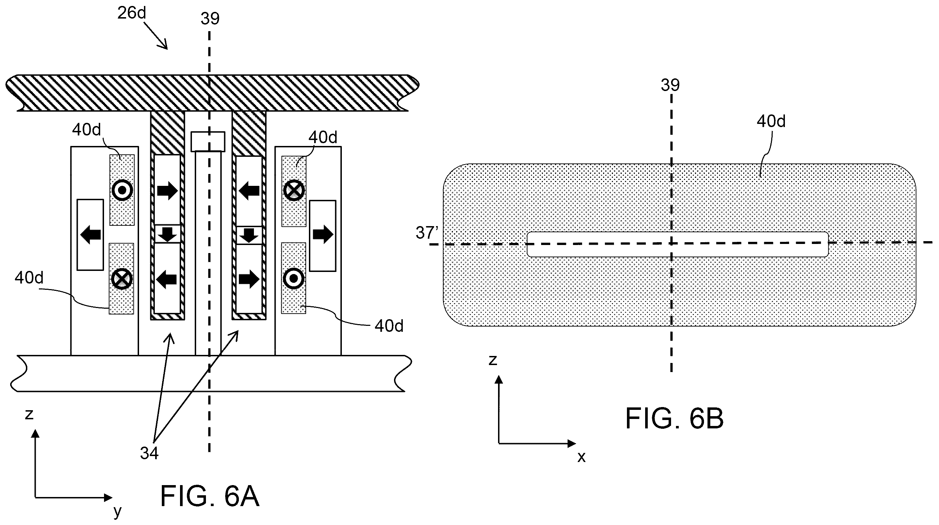

Figure 6A depicts a cross sectional side view of an actuator 26d of another embodiment. Although not apparent from Figure 6A, the actuator 26d of Figure 6A is different from the actuator 26 of Figure 3 in that the electromagnetic coils 40d are positioned and orientated differently. This is more apparent from Figure 6B which shows a side view of the electromagnetic coils 40d rotated by 90 degrees. A common axis 37' substantially parallel to the x direction, and which lies in the xy plane 37, is shown in Figure 6B. The common axis 39 substantially parallel to the z direction, and which also lies in the xy plane 37, is also shown. The electromagnetic coils 40d are aligned in the y direction with one electromagnetic coil 40d located on each side of the xz plane 37. Thus, the electromagnetic coils 40d do not encircle the second magnetic assembly 34, as the electromagnetic coils 40 do in Figures 3, 4A and 4B. The two electromagnetic coils 40d aligned in the y direction may be considered to extend parallel to the xz plane 37. The directions of the current of the electromagnetic coils may be as shown in Figure 6A.

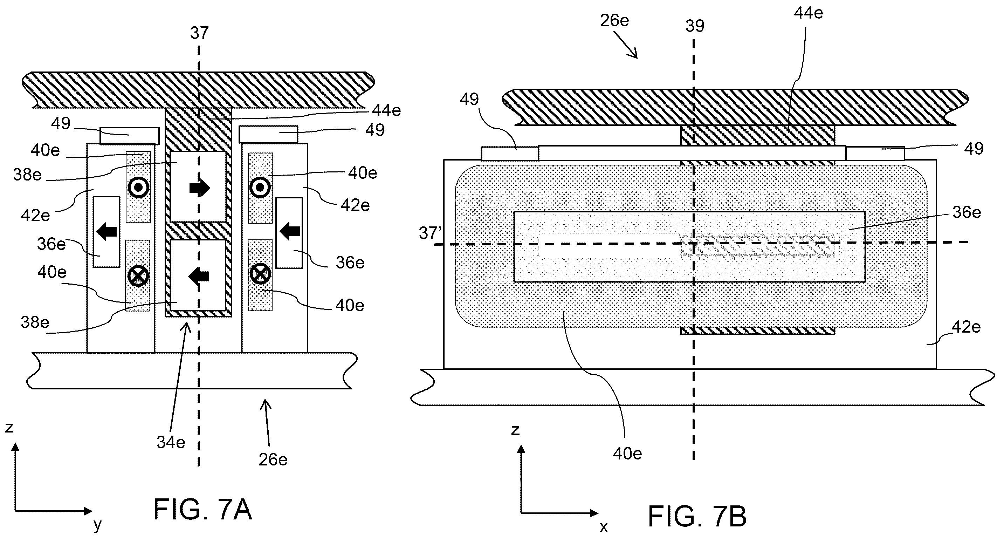

Figure 7A depicts a cross sectional side view of an actuator 26e of another embodiment. Figure 7B shows a side view of the actuator 26e rotated by 90 degrees. The actuator 26e of Figure 7A is similar to the actuator 26d of Figure 6A in that the electromagnetic coils 40e are positioned and orientated the same as the electromagnetic coils 40d of Figure 6A, albeit with the current of one of the electromagnetic coils 40e (the rightmost) being reversed. However, in actuator 26e, there are two second permanent magnets 38e instead of four. Furthermore, these second permanent magnets 38e are both centrally positioned in the actuator 26e in the y direction. That is, the two second permanent magnets 38e are aligned in the z direction and the two second permanent magnets 38e are at least partially located in the xz plane 37 in which lies the common axis 37' substantially parallel to the x direction (and the common axis 39 substantially parallel to the z direction). It will be appreciated that this is just an embodiment and there may be a different number of magnets and arrangements. For example, there may be a single second permanent magnet instead of two second permanent magnets (although this may be less efficient than the two second permanent magnets). In this case, the single second permanent magnet may be magnetized in the z direction (i.e. orientated such that its magnetic polarization is parallel to the z direction).

Furthermore, the magnetic polarization of one the first permanent magnets 36e (i.e. at the right side) has been reversed (see direction of arrow) when compared to the first permanent magnets of Figure 6A. That is, the first permanent magnets 36e are orientated such that their magnetic polarization is in the same direction as each other (e.g. in this case both towards the left [i.e. anti-parallel to the y direction]).

In addition, instead of the stroke pin 48 as in Figure 3, there is a crash rim 49 around, and protruding slightly inwardly of, an inner circumference of an electromagnetic coil body 42e. The second permanent magnets 38e are located in a magnetic housing 44e. The magnetic housing 44e coming into contact with the crash rim 49 constrains the motion of the second magnetic assembly 34e in both the x and the y directions. It will be appreciated that, in other embodiments, the crash rim may have a variety of sizes and shapes and be placed in various ways.

The actuator (e.g. actuator 26-26e as described above in Figures 3-7B) which allows increased relative displacement of the short stroke module and the long stroke module in the step (x) direction enables a new scanning method as described below. That is, the increased movement range of the short stroke module in the step (x direction) facilitates a new associated exposure motion pattern for the lithographic apparatus. Previously the range of motion of the z-actuator (in the x direction) would not have allowed the necessary relative movement of the short stroke module and the long stroke module (in the x direction) for this motion pattern.

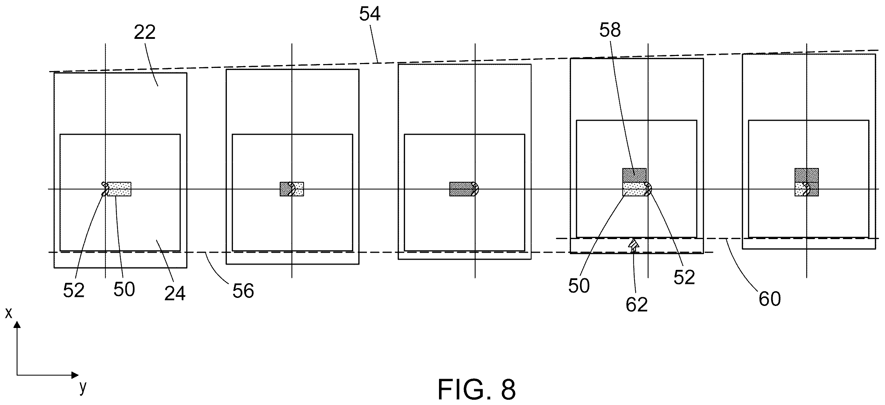

Figure 8 depicts the long stroke module 22 (i.e. a carrier on long stroke) and the short stroke module 24 (i.e. mirror block on short stroke) at different times during exposures of fields of a substrate W in a lithographic apparatus LA. The first (i.e. leftmost) depiction is the start of exposure i for an i field 50. A slit 52 is fixed and the long stroke module 22 and the short stroke module 24 are moving below the slit 52. The long stroke module 22 moves with a constant velocity of Vx in the x direction for a sequence of exposures (as illustrated by the diagonal dashed line 54 at top of Figure 8). The sequence of exposures may be considered to be a row of exposures (the row extending in the x direction towards the top of Figure 8).

The long stroke module 22 moves with a velocity of Vy in the y direction (i.e. parallel to the y direction) for exposure i in the sequence of exposures. The second depiction (moving left to right) is the middle of exposure i for the i field 50 and the third depiction is the end of exposure i for the i field 50. The short stroke module 24 moves a velocity of -Vx in the x direction (i.e. anti-parallel to the x direction) during the exposure i. This movement of the short stroke module 24 anti-parallel to the x direction (i.e. towards the bottom in Figure 8) matches the movement of the long stroke module 22 parallel to the x direction (towards the top in Figure 8) such that the projection image is maintained in a predetermined position below the slit 52 so that the i field 50 has the radiation incident thereon. That is, while scanning a field, the short stroke module 24 moves with respect to the long stroke module 22 at exactly the inverse of the constant velocity Vx of the long stroke module 22 so that the i field 50 stays under the slit 52. This is illustrated by the straight dashed line 56 at the bottom of Figure 8, which shows that the position of the short stroke module 24 does not move with respect to the slit 52, even though the position of the short stroke module 24 does move relative to the long stroke module 22.

The fourth depiction shows that, at the start of exposure i+1, the short stroke module 24 has rapidly stepped in the x direction to the next field 58 (i.e. i+1 field). That is, the short stroke module 24 moves, at the end of exposure i, at a velocity >Vx in the x direction to the position for the next exposure (i.e. exposure i+1). This x-step is the field width (e.g. may be 26mm or about 26mm). This x-step is illustrated by the straight dashed line 60 at the bottom of Figure 8, which shows that the position of the short stroke module 24 has now moved (see arrow 62) with respect to the slit 52 (and with respect to the long stroke module 22) so that the i+1 field 58 is in the predetermined position below the slit 52. The long stroke module 22 does not move to the position for the exposure i+1 (since this is done fully by the short stroke module 24).

When the scan for exposure i ends, the short stroke module 24 accelerates to the next field (the step [x] motion), while the long stroke module 22 (i.e. the carrier) reverses the scan [y] direction. At the same time as the x-step by the short stroke module 24, the long stroke module 22 reverses the y motion. That is, the long stroke module 22 then moves with a velocity of -Vy in the y direction (i.e. anti-parallel to the y direction) for exposure i+1 in the sequence of exposures. The long stroke module 22 is configured to alternately move at a velocity of Vy and -Vy in the y direction for alternate exposures of a sequence of exposures. The last (i.e. rightmost) depiction in Figure 8 shows the middle of exposure i+1. As with exposure i, the short stroke module 24 moves a velocity of -Vx in the x direction during the exposure i+1. This movement of the short stroke module 24 anti-parallel to the x direction (i.e. towards the bottom in Figure 8) again matches the movement of the long stroke module 22 parallel to the x direction (towards the top in Figure 8) such that the projection image is maintained in a predetermined position below the slit 52 so that the i+1 field 58 has the radiation incident thereon. It will be appreciated, that at the end of exposure i+1, the short stroke module 24 moves at a velocity >Vx in the x direction to the position for exposure i+2, and continues in this manner for the whole sequence of exposures (i.e. to the end of the row).

This (scanning and stepping) motion pattern method for the lithographic apparatus has an advantage of increasing acceleration in the y (scanning) direction. This is because freed up long stroke forcers may be dedicated to increase acceleration in the y direction since, previously, these long stroke forcers may have provided acceleration in the x (step) direction. The motion that requires high acceleration is the step (in the x direction) between fields. Making this x-step motion with the short stroke module 24 instead of the long stroke module 22 allows for at least some of the long stroke forcers to be freed up to be used for movement in the y (scanning) direction) rather than being used to step between fields in the x direction. Acceleration in the x direction may be in range of at least one of: 100 to 200ms⁻² and 100 to 300ms⁻². Acceleration in the y direction may be in range of at least one of: 40 to 70ms⁻², 40 to 100ms⁻² and 40 to 150ms⁻².

In this embodiment, the short stroke module 24 moves the full x step to the next exposure but it will be appreciated that the short stroke module 24 may be configured to only move, at the end of each exposure, at a velocity >Vx in the x direction for at least part of a distance to a position for the next exposure. In this case, the long stroke module 22 may be configured to move the rest of the distance to the position for the next exposure. In this case, the long stroke module 22 would only move at a velocity of Vx in the x direction for part of the exposure for each exposure of the sequence of exposures and the short stroke module 24 would only move at a velocity of -Vx in the x direction during this part of the exposure such that a projection image is maintained in the predetermined position. That is, the velocity of the short stroke module 24 still matches the velocity of the long stroke module 22 over time. In addition, the velocity of the long stroke module 22 (and the corresponding velocity of the short stroke module 24) do not have to be constant (i.e. the velocity can be variable as long as it is matched accordingly). The acceleration in the x direction of the long stroke module 22 can be reduced substantially to an easily achievable level.

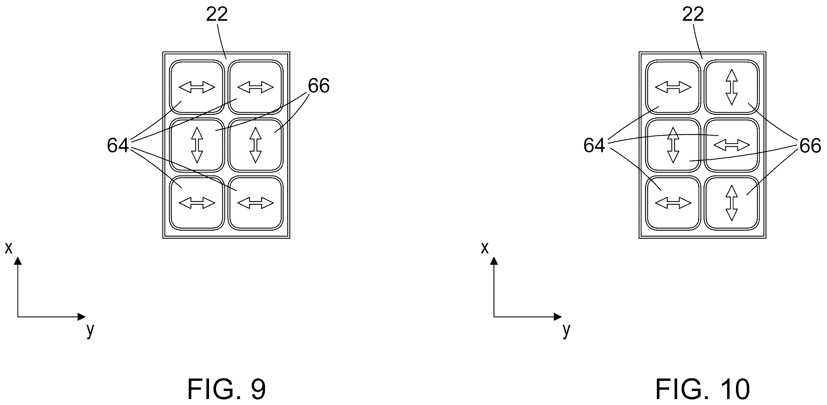

Figure 9 depicts a long stroke module 22 having six long stroke forcers. Four of these long stroke forcers are configured to provide movement in the y direction (i.e. four y long stroke forcers 64). Two long stroke forcers are configured to provide movement in the x direction (i.e. two x long stroke forcers 66). Each long stroke forcer contains 3 parallel coils. Each long stroke forcer provides two force directions. If the long direction of the coils is in y direction, then the forces are in the x and the z directions. If the long direction is in the x direction, then the forces are in y and the z directions. By combining several forcers (e.g. 4 or 6) then there are e.g. 8 or 12 independent settings, with which all 6 degrees of freedom may be driven with some redundancy. It will be appreciated that this is just an embodiment and there may be a different number of x and/or y long stroke forcers.

Using the short stroke module 24 in such a way as described in Figure 8 allows the long stroke forcers to be used differently from previously. For example, instead of four long stroke forcers providing the step acceleration (as may have been done previously), two or three long stroke forcers may be used to provide the step acceleration (in the x direction), while dedicating the freed up long stroke forcers to increase acceleration in the scan (y) direction. Therefore this will provide increased scan (y) acceleration. This may increase productivity of the lithographic apparatus LA by reducing the time between successive exposures.

Figure 10 depicts a long stroke module 22 having six long stroke forcers in another embodiment. Three of these long stroke forcers are configured to provide movement in the y direction (i.e. three y long stroke forcers 64). Three long stroke forcers are configured to provide movement in the x direction (i.e. three x long stroke forcers 66). Three x long stroke forcers 66 and three y long stroke forcers 64 may provide an acceleration capability of long stroke of 70 m/s2 in both step (x) and scan (y) direction. It may not be possible to add additional long stroke forcers onto the long stroke module as it may be entirely covered with the six long stroke forcers (i.e. there is no room to place extra forcers). Thus, acceleration in the y and x direction is limited based on the number of long stroke forcers and the directions of the force they provide.

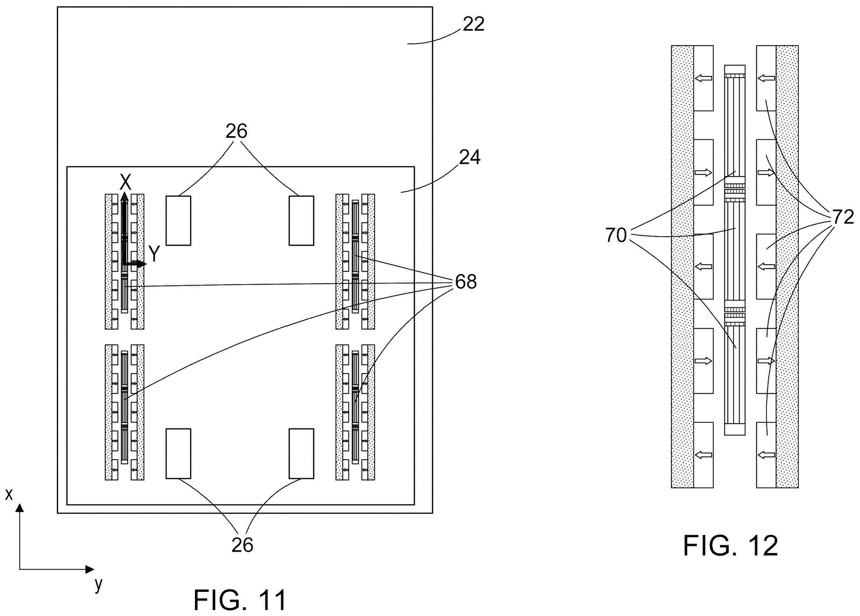

Figure 11 depicts a short stroke module 24 having four short stroke forcers 68. Each of these short stroke forcers 68 are configured to provide movement in both the x and the y direction. The short stroke forcers 68 are 3-phase linear motors. Each 3-phase linear motor generates both x and y force. The y force may be up to 60% of the x force. The x range may be 26mm, the y range may be 1mm or <1mm. An added benefit of 3-phase forcers is that torque control is provided to possibly counteract mirror block deformation. Each forcer may provide force, and thus movement, in two directions. For four forcers, this means that we have 4 x forces, 4 y forces (and from the z-forcers [i.e. z-actuators]) 4 z forces. Thus, there are 12 parameters to control a 6 degrees of freedom position. The redundancy can be used to counteract mirror block deformation.

As shown more clearly in Figure 12, each 3-phase linear motor comprises 3 motor coils 70 (a T-coil, a S-coil and a R-coil) and 5 alternating magnet sets 72 as the yoke. The motor coils are orientated in the y direction. The coils may be upright so that the mirror block can be lifted from the stage apparatus for maintenance without geometrical obstruction. The short stroke forcer may comprise at least one Halbach magnet. It will be appreciated that this is just an embodiment and there may be a different number and/or type of short stroke forcers. For example, the motors could be multi-phase linear motors (such as 2-phase or 5-phase motors) or could be LIMMS forcers Lorentz forcers (where each coil is wrapped around a magnetic core, which may be connected by a backing yoke). It will be appreciated that this is just an embodiment and there may be a different number of magnets and number of coils. Furthermore, the magnets may be slanted to reduce variations in the motor constant (e.g. variation as function of position of the amount of Newtons per applied current). A slanted magnetic orientation may be used to provide for less cogging (motion force vs position).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An actuator for a stage apparatus of a lithographic apparatus, the actuator comprising:
first and second magnetic assemblies, the first magnetic assembly is attached to a long stroke module or a short stroke module and comprises at least two first permanent magnets, the second magnetic assembly is attached to the short stroke module or the long stroke module and comprises at least one second permanent magnet, and the first and second magnetic assemblies are configured to magnetically cooperate with one another to support the short stroke module with respect to the long stroke module in a first direction, wherein one first permanent magnet is located on each side of a plane in which lies a common axis substantially parallel to a second direction perpendicular to the first direction, and wherein the second magnetic assembly is located between the first permanent magnets in a third direction substantially perpendicular to both the first and second directions, and
an electrically conductive element connectable to a power supply, the electrically conductive element being configured to control a force in the first direction exerted on the second magnetic assembly from the first magnetic assembly,
wherein the first magnetic assembly is longer than the second magnetic assembly in the second direction to enable relative displacement of the short stroke module and the long stroke module in the second direction and the first magnetic assembly is geometrically configured such that a substantially homogeneous parallel magnetic field is provided for a range of position of the second magnetic assembly in the second and/or third directions.

2. The actuator of claim 1, wherein the electrically conductive element is an electromagnetic coil located between the first magnetic assembly and the second magnetic assembly or located externally to the first magnetic assembly.

3. The actuator of claim 2, wherein the electromagnetic coil is longer in the second direction than in the third direction to enable the relative displacement of the short stroke module and the long stroke module in the second direction.

4. The actuator of either of claims 2 or 3, wherein the electromagnetic coil is configured to be mounted to the long stroke module or the short stroke module.

5. The actuator of any of claims 2-4, wherein the electrically conductive element comprises at least two electromagnetic coils, wherein the at least two electromagnetic coils are aligned in the first direction or aligned in the third direction with one electromagnetic coil located on each side of the plane in which lies the common axis substantially parallel to the second direction.

6. The actuator of any preceding claim, wherein the first and second magnetic assemblies are at least substantially reflectional symmetric around the plane in which lies the common axis substantially parallel to the second direction.

7. The actuator of any preceding claim, wherein the first magnetic assembly comprises at least four first permanent magnets with at least two first permanent magnets on each side of the plane in which lies the common axis substantially parallel to the second direction, wherein the two first permanent magnets on each side are aligned in the second direction.

8. The actuator of any preceding claim, wherein the second magnetic assembly comprises at least two second permanent magnets and wherein at least one of:
one second permanent magnet is located on each side of the plane in which lies the common axis substantially parallel to the second direction; and
the two second permanent magnets are aligned in the first direction and the two second permanent magnets are located at the common axis substantially parallel to the first direction.

9. The actuator of claim 8, wherein the second magnetic assembly comprises at least four second permanent magnets with at least two second permanent magnets on each side of the plane in which lies the common axis substantially parallel to the second direction, wherein the two second permanent magnets on each side are aligned in the first direction.

10. The actuator of any preceding claim, wherein the first and second permanent magnets are plane-parallel planar shaped magnets, wherein an in-plane dimension of the second permanent magnet or magnets in the second direction is substantially smaller than a corresponding dimension of the first permanent magnets.

11. A stage apparatus of a lithographic apparatus, the stage apparatus comprising the actuator of any preceding claim.

12. The stage apparatus of claim 11, wherein the stage apparatus comprises the short stroke module and the long stroke module, wherein the long stroke module is configured to:
alternately move at a velocity of Vy and -Vy in the third direction for alternate exposures of a sequence of exposures and a velocity of Vx in the second direction for at least part of the exposure for each exposure of the sequence of exposures;
and the short stroke module is configured to:
move at a velocity of -Vx in the second direction during the at least part of the exposure such that a projection image is maintained in a predetermined position, and
move, at the end of each exposure, at a velocity >Vx in the second direction for at least part of a distance to a position for the next exposure.

13. The stage apparatus of claim 11, wherein the long stroke module is configured to:
move at the velocity of Vx in the second direction for the sequence of exposures;
and the short stroke module is configured to:
move at a velocity of -Vx in the second direction during each exposure such that the projection image is maintained in the predetermined position, and
move, at the end of each exposure, at a velocity >Vx in the second direction to the position for the next exposure.

14. The stage apparatus of either of claims 12 or 13, wherein the long stroke module comprises a plurality of long stroke forcers, and wherein an equal number or a majority of the long stroke forcers are configured to provide movement in the third direction and an equal number or a minority of the long stroke forcers are configured to provide movement in the second direction.

15. The stage apparatus of any of claims 12-14, wherein the short stroke module comprises a plurality of short stroke forcers, and wherein the short stroke forcers comprise at least one of: forcers configured to provide movement in both the second and third directions, and 3-phase linear motors.

16. A lithographic apparatus comprising the actuator of any of claims 1-10 or the stage apparatus of any of claims 11-15.

17. The lithographic apparatus of claim 16, wherein the lithographic apparatus is an EUV lithographic apparatus.

18. A method comprising providing an actuator for a stage apparatus of a lithographic apparatus, the method comprising providing:
first and second magnetic assemblies, the first magnetic assembly is attached to a long stroke module or a short stroke module and comprises at least two first permanent magnets, the second magnetic assembly is attached to the short stroke module or the long stroke module and comprises at least one second permanent magnet, and the first and second magnetic assemblies are configured to magnetically cooperate with one another to support the short stroke module with respect to the long stroke module in a first direction, wherein one first permanent magnet is located on each side of a plane in which lies a common axis substantially parallel to a second direction perpendicular to the first direction, and wherein the second magnetic assembly is located between the first permanent magnets in a third direction substantially perpendicular to both the first and second directions, and
an electrically conductive element connectable to a power supply, the electrically conductive element being configured to control a force in the first direction exerted on the second magnetic assembly from the first magnetic assembly,
wherein the first magnetic assembly is longer than the second magnetic assembly in the second direction to enable relative displacement of the short stroke module and the long stroke module in the second direction and the first magnetic assembly is geometrically configured such that a substantially homogeneous parallel magnetic field is provided for a range of position of the second magnetic assembly in the second and/or third directions.

19. The method of claim 18, wherein the stage apparatus comprises the short stroke module and the long stroke module, the method comprising:
moving the long stroke module alternately at a velocity of Vy and -Vy in the third direction for alternate exposures of a sequence of exposures and a velocity of Vx in the second direction for at least part of the exposure for each exposure of the sequence of exposures;
moving the short stroke module at a velocity of -Vx in the second direction during the at least part of the exposure such that a projection image is maintained in a predetermined position, and
moving the short stroke module, at the end of each exposure, at a velocity >Vx in the second direction for at least part of a distance to a position for the next exposure.
